## Europäisches Patentamt
## European Patent Office
## Office européen des brevets

(19)

(11) Publication number: **0 034 929**
**B1**

(12)

# EUROPEAN PATENT SPECIFICATION

(45) Date of publication of patent specification: **09.05.84**

(51) Int. Cl.³: **H 01 L 23/56, H 01 L 27/02**

(21) Application number: **81300712.7**

(22) Date of filing: **20.02.81**

(54) Protection of a MISFET of a semiconductor integrated circuit device.

(30) Priority: **22.02.80 JP 21431/80**

(43) Date of publication of application:
**02.09.81 Bulletin 81/35**

(45) Publication of the grant of the patent:
**09.05.84 Bulletin 84/19**

(84) Designated Contracting States:
**DE FR GB**

(56) References cited:
**DE - A - 2 531 846**

(73) Proprietor: **FUJITSU LIMITED**
**1015, Kamikodanaka Nakahara-ku**
**Kawasaki-shi Kanagawa 211 (JP)**

(72) Inventor: **Wada, Kunihiko**
**7-1-1234, Sugita Isogo-ku**
**Yokohama-shi Kanagawa 235 (JP)**

(74) Representative: **Sunderland, James Harry et al,**
**HASELTINE LAKE & CO Hazlitt House 28**
**Southampton Buildings Chancery Lane**
**London WC2A 1AT (GB)**

Courier Press, Leamington Spa, England.

## Description

This invention relates to a protection circuitry for a MISFET (metal insulator semiconductor type field effect transistor) of a semiconductor integrated circuit device.

Protection circuits for MIS field effect transistors (hereinafter referred to as MISFET's) generally aim at the protection of the gate insulation films of the MISFET's. That is, a protection circuit protects a gate insulation film of a MISFET from breakdown in the event of a high potential, for example due to static electricity, being momentarily applied to an input terminal connected to the gate of the MISFET.

Recently, however, an increasing number of short-channel MISFET's have been manufactured, as elements integrated in semiconductor integrated circuit devices have been reduced more and more in size. This tendency to employ short-channel MISFET's requires that consideration be given to MISFET punch-through phenomenon, as well as to the breakdown of gate insulation films, for the protection of MISFET's.

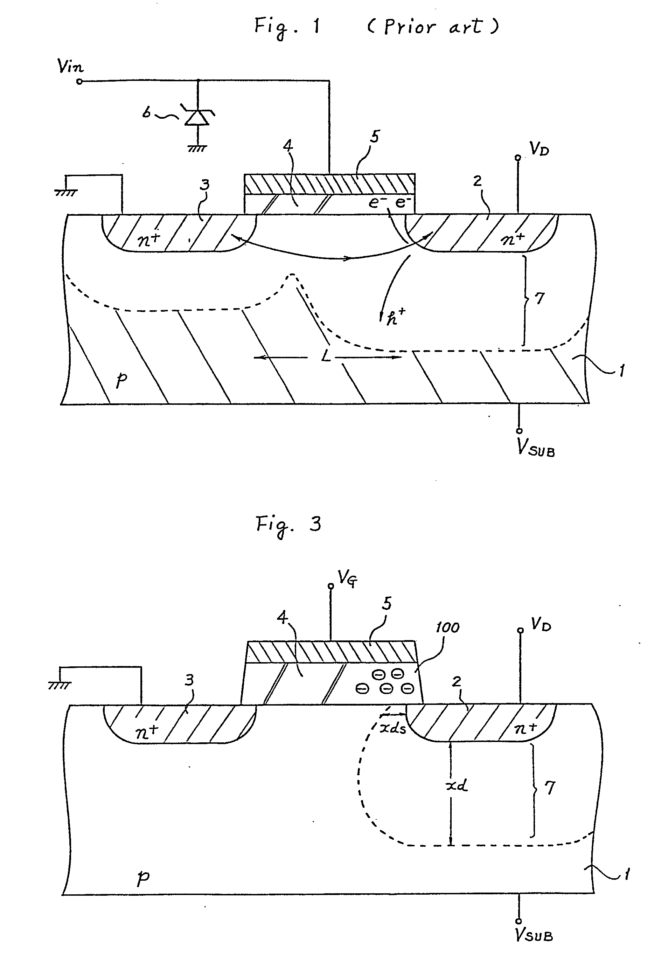

Figure 1 of the accompanying drawings is a schematic sectional view outlining the structure of a conventional MISFET. In Figure 1, 1 is a p type semiconductor substrate; 2 is an n type drain region; 3 is an n type source region; 4 is a gate insulated (insulation) film; and 5 is a gate. 6 is a protection device for preventing breakdown of the gate insulation film 4. In the case of Figure 1, a zener diode is used as the protec-tion device. $V_{in}$ is an input terminal. To provide drain voltage $V_D$, a high potential power source is connected to the drain region 2, and to provide source voltage a low potential power source is connected to the source region 3.

When a MISFET as illustrated in Figure 1 is subjected to miniaturisation, channel length L is reduced. As a result, a punch-through phenomenon, which is generated in dependence upon a depletion layer (e.g. 7) extending from the junctions between the drain 2 and source 3 and the substrate 1, occurs more easily. That is, as the channel becomes shorter and shorter, the drain voltage $V_D$ required to generate the punch-through phenomenon is reduced. When the punch-through phenomenon occurs, an excessive current flows through the channel and hot carriers which are generated by impact ionization of carriers occurring in the vicinity of drain are trapped in the gate insulation film 4. As a result, a threshold voltage of the MISFET changes or a leakage current of the junction area between the drain 2 and the substrate 1 increases. This phenomenon causes deterioration of the MISFET, that is, the MISFET wears out.

US—A—4 115 709 discloses the use of a gate controlled diode to protect against drain junction surface breakdown in a MISFET.

According to the present invention there is provided protection circuitry in combination with a MISFET of a semiconductor integrated circuit device for protecting the MISFET, the MISFET having first and second regions of one conductivity type, formed in a semiconductor substrate of the opposite conductivity type, connected respectively to first and second power supply terminals, and a gate provided on a gate insulation film on the semiconductor substrate between the first and second regions, the MISFET being such that a punch-through voltage which, if applied from a power supply terminal to the region connected to that power supply terminal, would give rise to a punch-through phenomenon in the MISFET, is less than a breakdown voltage of the PN junction between the substrate and the region to which that power supply terminal is connected, wherein the protection circuitry comprises at least one protection means having a predetermined breakdown voltage connected in parallel with a charge flow path between the first power supply terminal and the first region or in parallel with a charge flow path between the second power supply terminal and the second region, to prevent the application of the excessive voltage to the first region or to prevent the application of an excessive voltage to the second region respectively, the or each protection means having a breakdown voltage less than a punch-through voltage which, if applied from the power supply terminal in respect of which the protection means is connected to the region connected to that power supply terminal, would give rise to a punch-through phenomenon in the MISFET.

The protection means is, for example, connected between the drain power supply and a substrate of the semiconductor integrated circuit device in which the MISFET drain is formed.

An embodiment of the present invention provides a semiconductor integrated circuit device with protection means for preventing the flow of an excessive current into the channel of a MISFET as a result of MISFET punch-through in a MISFET having a short channel.

An embodiment of the present invention provides a semiconductor integrated circuit device with protection means which prevent a voltage higher than a punch-through voltage being applied to the source of a MISFET.

Reference is made, by way of example, to the accompanying drawings, in which:—

Figure 1 is a schematic sectional view outlining a conventional general MISFET;

Figure 2 is a graph illustrating the relationship between channel length and punch-through voltage for MISFET's;

Figure 3 is a schematic sectional view for assistance in explanation of breakdown occurring as a result of a punch-through phenomenon in a MISFET;

Figure 4 is a schematic circuit diagram illustrating an embodiment of the present invention;

Figures 5 and 6 are respective schematic sectional views for assistance in explanation of operation of a gate control diode employed in an embodiment of the present invention;

Figure 7 is a graph illustrating breakdown voltage characteristics of a gate control diode of an embodiment of the present invention; and

Figures 8, 9 and 10 are respective schematic sectional views of semiconductor integrated circuit devices embodying the present invention.

The punch-through phenomenon occurring in a MISFET having a short channel is explained below in some detail.

A punch-through voltage, which is for example a drain voltage at which a punch-through phenomenon occurs, is proportional to the square of the channel length L of a MISFET. Therefore, the smaller the channel length L, as elements are more and more decreased in size, the lower the punch-through voltage $V_{PT}$. The relationship between L and $V_{PT}$ is illustrated in the graph of Figure 2.

The graph of Figure 2 shows the relationship between the channel length L and the drain voltage $V_{PT}$ which causes a punch-through phenomenon, in relation to a case in which source and gate electrodes are grounded, and in relation to MISFET's in which n type source and drain regions are doped to a depth of 250 nm (2500 Å), with an impurity concentration of $1 \times 10^{20} cm^{-3}$, and in which gate insulation films of a thickness of (400 Å) (40 nm) are provided on p type semiconductor substrates with an impurity concentration of $1.5 \times 10^{15} cm^{-3}$.

At channel lengths such that the punch-through voltage $V_{PT}$ becomes higher than the breakdown voltage $V_{PN}$ of the PN junction between the drain and substrate, $V_{PT}$ takes a constant value, that is, for channel lengths L larger than a specified value $V_{PT}$ is constant. In other words, in the case of a MISFET having a channel length L of as much as approximately 8 $\mu m$, because the relationship $V_{PT} > V_{PN}$ holds, even if an excessive voltage is applied to the drain of the MISFET, breakdown of the drain substrate PN junction occurs, and the punch-through phenomenon is not allowed to occur.

However, when the channel length L is reduced to 2 $\mu m$, the relationship mentioned above is reversed, so that $V_{PT} < V_{PN}$, and thereby punch-through phenomenon occurs before PN junction breakdown.

PN junction breakdown has little effect on the characteristics of the (MISFET) element, but the punch-through phenomenon can influence the characteristics of the (MISFET) element significantly. Namely, an excessive current flows through the channel of a MISFET as a result of the punch-through phenomenon, electric field is concentrated in the depletion layer in the drain region channel vicinity, electrons, in other words carriers, are accelerated by such electric field, impact ionization occurs and thereby hot holes $(h^+)$ and hot electrons $(e^-)$ are generated. Then, the hot electrons are trapped in the gate insulation film. As a result, the threshold voltage of MISFET changes or the breakdown leakage current of the PN junction is increased.

Particularly, an increase of breakdown leakage current poses a very important problem. Figure 3 shows a sectional view of a MISFET for assistance in explanation of this phenomenon. In Figure 3, 100 represents charges trapped in the gate insulation film 4. Under the conditions illustrated in Figure 3, the depletion layer 7 extending from the PN junction between the drain 2 and the substrate 1 is excessively reduced in size in the vicinity of the surface of substrate 1 $(x_{ds} < x_d)$. As a result, the PN junction breakdown voltage is reduced, allowing an increase in leakage current in the vicinity of trapped charges. This phenomenon is a problem to be noted particularly because it is generated even when the trapping of charges occurs at a point.

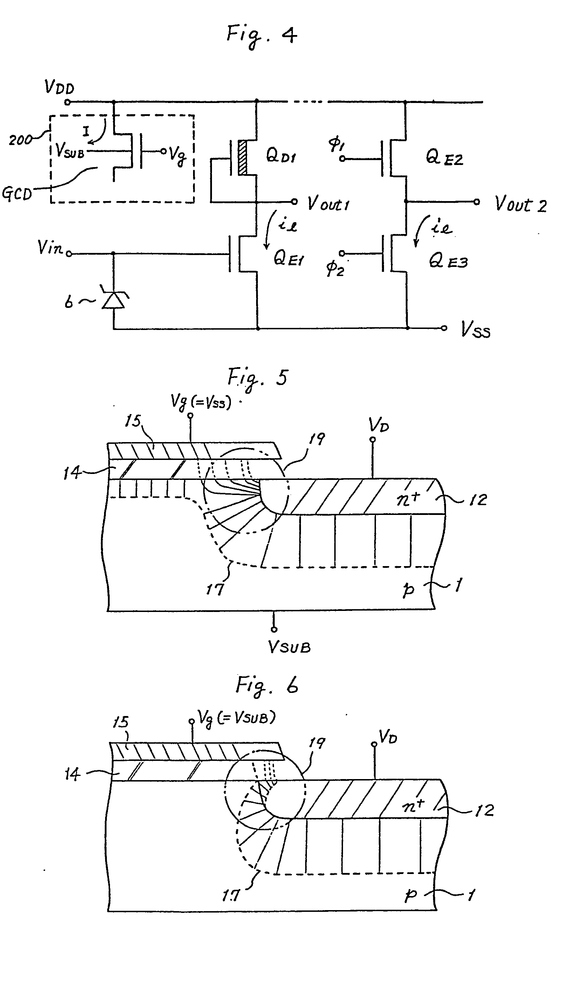

Figure 4 is a schematic circuit diagram of an embodiment of the present invention. Generally, in a circuit using MISFET's, load transistors and drive transistors are connected in series between a high potential power source $V_{DD}$ and a low potential power source $V_{SS}$, in the way in which $Q_{D1}$, $Q_{E1}$ and $Q_{E2}$, $Q_{E3}$ are connected in series in Figure 4.

In Figure 4, $Q_{D1}$ is a depletion type MISFET and $Q_{E1}$, $Q_{E2}$, $Q_{E3}$ are enhancement type MISFET's. $V_{in}$ is an external input signal; $\phi_1$, $\phi_2$ are internal signals; $V_{out1}$, $V_{out2}$ are output signals. 6 is a zener diode which protects the gate insulation film of $Q_{E1}$.

The high potential power source $V_{DD}$ and low potential power source $V_{SS}$ are connected via external terminals in an integrated circuit device. If a high voltage, for example resulting from static electricity, is applied even momentarily, the punch-through phenomenon occurs at the driver transistors $Q_{E1}$, $Q_{E3}$ in the OFF condition. As a result, leakage current $i_1$ increases and, for example, a high level of the output signals $V_{out1}$, $V_{out2}$ can no longer be maintained.

For this reason, protection means 200 are provided between high potential power source $V_{DD}$ and MISFET drain region (e.g. in parallel to the high potential power source $V_{DD}$ — drain region current path) in the embodiment of Figure 4. Protection means 200 are so designed as to have a breakdown voltage characteristic which is lower than the punch-through voltage of short channel MISFET's $Q_{E1}$, $Q_{E3}$, and which is higher than the voltage of the (normal) high potential power source $V_{DD}$ plus a power source margin (e.g. an allowed margin of variation of power source potential). Therefore, when an excessive voltage is applied to $V_{DD}$, the protection means 200 break down preventing the application of an excessive voltage higher than the punch through voltage to the drains of $Q_{E1}$, $Q_{E3}$.

As protection means 200 in Figure 4, a gate control diode GCD, the breakdown voltage of which can be controlled easily by means of a gate voltage $V_g$, can be employed, so that the requirement for the breakdown voltage to be higher than $V_{DD}$ (when within normal limits) but lower than the punch-through voltage $V_{PT}$ and, of course, lower than PN junction breakdown voltage $V_{PN}$ can be met.

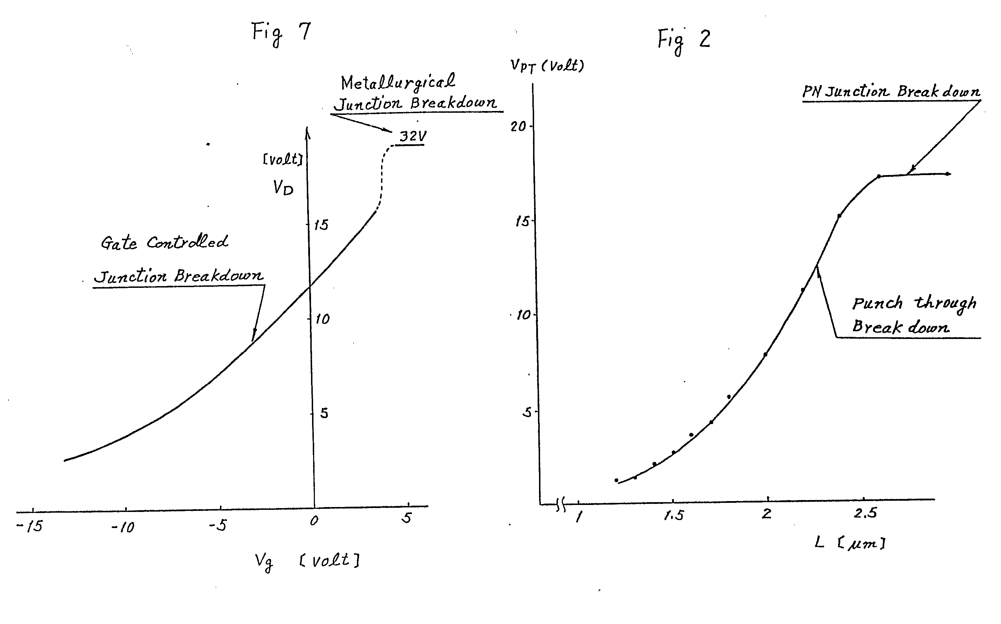

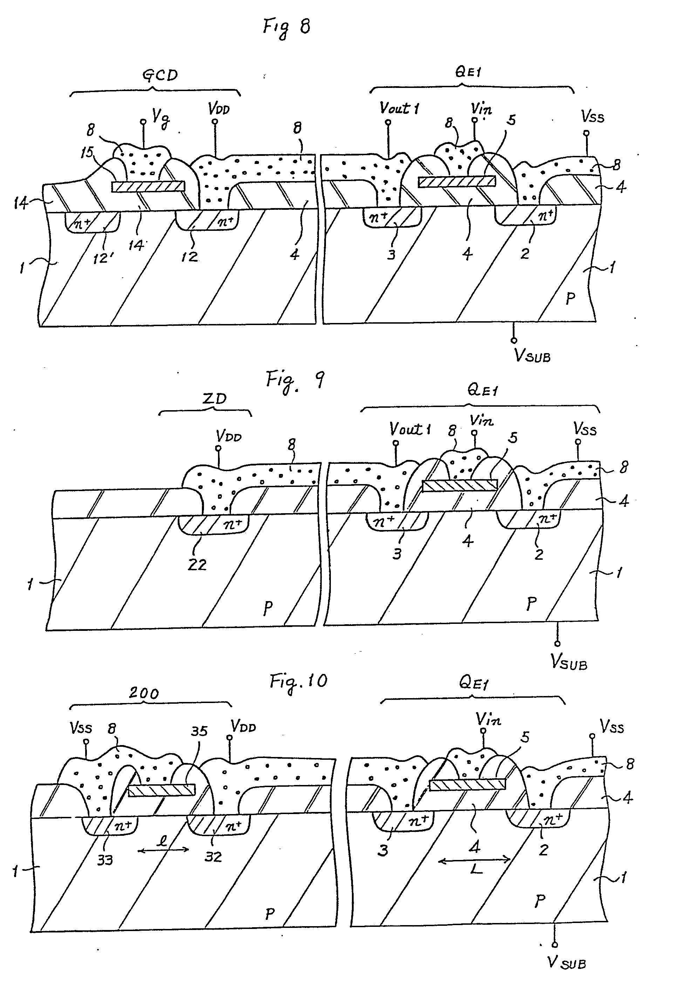

The operations of such a gate control diode GCD are explained with reference to the sectional views of Figures 5 and 6, and a breakdown voltage characteristic curve of Figure 7.

The GCD has a structure similar to that of an ordinary MISFET. Namely, $n^+$ region 12 is provided on the surface of p type semiconductor substrate 1 and a gate 15 is provided via an insulation film 14 on the substrate 1. A diode is formed by the PN junction between the $n^+$ region 12 and the substrate 1.

In the case of this GCD, junction breakdown voltage can be controlled by gate voltage $V_g$. In other words, as illustrated by the graph of Figure 7, the smaller the gate voltage $V_g$, the lower the breakdown voltage. The graph of Figure 7 relates to GCD's for which impurity concentration in the substrate 1 is $1.5 \times 10^{15} \text{cm}^{-3}$, impurity concentration in the $n^+$ region 12 is $1.0 \times 10^{20} \text{cm}^{-3}$, depth of 12 is (2500 Å) (250 nm), thickness of the insulation film 14 is 40 mm (400 Å) and substrate potential $V_{SUB}$ is $-2$ volts.

In Figure 5, in which it is taken that ground potential is applied as gate voltage $V_g$, a depletion layer extends as indicated by broken line 17 (electric lines of force indicating electric field distribution in the depletion layer are shown in Figure 5), the electric field is concentrated in an area 19 as a result of the influence of the gate 15, and breakdown rapidly occurs from this area. Therefore, the breakdown voltage of this area is about 12V, which is lower than that of an ordinary zener diode.

In Figure 6, it is taken that a substrate voltage $V_{SUB}$ ($-3$V) is applied as gate voltage $V_g$. In this Figure, electric field is more concentrated at area 19 and the breakdown voltage $V_{GCD}$ of GCD is further reduced.

For gate voltage $V_g$ above a specified high voltage value, the breakdown voltage $V_{GCD}$ is saturated at a constant value (e.g. 32V). This phenomenon is known as Metallurgical Junction Breakdown and occurs because when the gate voltage $V_g$ is increased beyond the specified value, a depletion layer between the substrate and $n^+$ layer 12 can not extend any further.

Figure 8 is a sectional view of a semiconductor device embodying this invention wherein a gate control diode GCD is formed on the same substrate 1 as a MISFET. As illustrated in the schematic diagram of Figure 4, the GCD is provided at an area between the drain 3 of transistor $Q_{E1}$, which transistor is to be protected, and the high voltage power source $V_{DD}$ (e.g. GCD is provided in parallel to the drain $3 - V_{DD}$ current path). An excessive voltage applied to $V_{DD}$ is discharged to the substrate 1 from the GCD, whereby $Q_{E1}$ is protected.

In the embodiment of Figure 8, the GCD is formed by the same processes as those used for forming $Q_{E1}$ (and other MISFET's). Therefore, the breakdown voltage of the PN junction between the substrate 1 and $n^+$ region 12 is about 17 volts, as in the case of a conventional zener diode. When ground potential $V_{SS}$, which is generally used as a power source potential of a semiconductor integrated circuit device, or a negative substrate voltage $V_{SUB}$ (about $-3$V), is applied as gate voltage $V_g$, the breakdown voltage can be substantially reduced. Namely, when $V_g$ is ground potential, $V_{GCD}$ is about 12V, and when $V_g$ is substrate potential, $V_{GCD}$ is about 9V, which voltages are lower than the punch-through voltage of a short channel MISFET. Of course, the $V_{GCD}$ can be set freely by applying other voltages. In other words, novel manufacturing processes are not needed for realisation of the embodiment of Figure 8.

Figure 9 is a sectional view illustrating another embodiment of the present invention. In this embodiment, a zener diode ZD is used as protection means 200 of Figure 4. In Figure 9, 22 is an $n^+$ region and the protection means utilises the breakdown of the PN junction between substrate 1 and $n^+$ region 22. In this case, in order to make the breakdown voltage of the zener diode ZD less than the punch-through voltage, the impurity concentration of the substrate 1 at the ZD portion thereof, and that of the $n^+$ region 22, are controlled.

Figure 10 is a sectional view illustrating another embodiment of this invention. In this embodiment, a punch-through type MISFET is provided as protection means 200. In Figure 10, 32 is a drain, 33 is a source and 35 is a gate. Gate 35 and source 33 are kept at ground potential $V_{SS}$. Breakdown of the protection means is generated by the MISFET punch-through phenomenon. Channel length L is so controlled that optimum punch-through voltage is selected.

As explained in detail above, according to an embodiment of the present invention, in a semiconductor integrated circuit device comprising MISFET's, when a punch-through voltage is lower than the breakdown voltage of the PN junction between the substrate and the drain of a MISFET, as a result of the MISFET having a shorter channel to meet significant miniaturization requirements, protection means having a breakdown voltage lower than the punch-through voltage are provided between the drain and the high voltage power source. Therefore, generation of punch-through phenomenon in the short channel MISFET can be prevented, and breakdown of elements due to the punch-through phenomenon can also be prevented, thus improving reliability.

In the above explanation of the described embodiments of this invention, protection means 200 are provided between the drain and high voltage power source $V_{DD}$ of a MISFET; however, the punch-through phenomenon of a MISFET can also be prevented in a similar fashion by providing protection means 200 between the source and the low voltage power source $V_{SS}$ of a MISFET.

Thus, an embodiment of the present invention provides protection circuitry for a MISFET of a semiconductor integrated circuit device comprising MIS field effect transistors having drain and source regions of one conductivity type in a semiconductor substrate of the opposite conductivity type, and a gate provided via a gate insulation film on the substrate between the drain and source regions of the MIS field effect transistors. As MISFET channel length is reduced, MISFET punch-through voltage falls below the breakdown voltage of the MISFET PN junction between, for example, drain and substrate.

In an embodiment of the present invention, protection circuitry provides protection means, having a breakdown voltage less than the punch-through voltage, between the drain region and the high voltage power source supplying the drain region, in order to prevent deterioration or wearout of MISFET element characteristics as a result of the punch-through phenomenon. As protection means, a gate control diode is preferred.

Alternatively, or in addition the protection circuitry may provide protection means between the source region and the low voltage power source supplying the source region. As MISFET channel length is reduced, the punch-through voltage of the MISFET falls below the breakdown voltage of the PN junction between source and substrate, and the punch-through phenomenon can be caused by excessive voltage applied to the source region.

**Claims**

1. Protection circuitry in combination with a MISFET of a semiconductor integrated circuit device, for protecting the MISFET the MISFET having first and second regions (2, 3) of one conductivity type, formed in a semiconductor substrate (1) of the opposite conductivity type, connected respectively to first and second power supply terminals ($V_{SS}$, $V_{DD}$), and a gate (5) provided on a gate insulation film (4) on the semiconductor substrate between the first and second regions, the MISFET being such that a punch-through voltage which, if applied from a power supply terminal to the region connected to that power supply terminal, would give rise to a punch-through phenomenon in the MISFET, is less than a breakdown voltage of the PN junction between the substrate and the region to which that power supply terminal is connected, wherein the protection circuitry comprises at least one protection means (200) having a predetermined breakdown voltage connected in parallel with a charge flow path between the first power supply terminal and the first region or in parallel with a charge flow path between the second power supply terminal and the second region, to prevent the application of an excessive voltage to the first region or to prevent the application of an excessive voltage to the second region respectively, the or each protection means having a breakdown voltage less than a punch-through voltage which, if applied from the power supply terminal in respect of which the protection means is connected to the region connected to that power supply terminal, would give rise to a punch-through phenomenon in the MISFET.

2. Protection circuitry in combination with a MISFET, as claimed in claim 1, comprising protection means having a predetermined breakdown voltage and connected in parallel with a charge flow path between the first power supply terminal and the first region, and comprising protection means having a predetermined breakdown voltage and connected in parallel with a charge flow path between the second power supply terminal and the second region, to prevent the application of excessive voltages to the first and second regions.

3. Protection circuitry in combination with a MISFET, as claimed in claim 1 or 2, wherein the or each protection means operates to provide a by-pass path for charges when an excessive voltage is applied from the power supply terminal to which the protection means is connected.

4. Protection circuitry in combination with a MISFET, as claimed in any preceding claim, wherein the or each protection means comprises a gate control diode, to a gate of which a predetermined voltage is applied to set a breakdown voltage for the gate control diode lower than a punch-through voltage of the MISFET.

5. Protection circuitry in combination with a MISFET, as claimed in claim 4, wherein the predetermined voltage is ground potential.

6. Protection circuitry in combination with a MISFET, as claimed in claim 4, wherein the predetermined voltage is substrate voltage.

7. Protection circuitry in combination with a MISFET, as claimed in any one of claims 1 to 3, wherein the or each protection means comprises a zener diode the breakdown voltage of which is less than a punch through voltage of the MISFET.

8. Protection circuitry in combination with a MISFET, as claimed in any one of claims 1 to 3, wherein the or each protection means comprises a punch-through type MISFET having a punch-through voltage less than a punch-through voltage of the MISFET to be protected.

9. Protection circuitry in combination with a MISFET, as claimed in any preceding claim, wherein the protection means are provided on the said semiconductor substrate.

10. Protection circuitry in combination with a MISFET, as claimed in any preceding claim, wherein the first region is a MISFET drain region, the second region is a MISFET source region, the first power supply terminal is a high voltage power supply terminal, and the second power supply terminal is a low voltage power supply terminal.

## Patentansprüche

1. Schutzschaltung in Kombination mit einem MIS-Feld-effekttransistor in einer integrierten Halbleiterschaltung, zum Schutz des MIS-Feldeffekttransistors, mit einem ersten und einem zweiten Bereich (2, 3) einer Leitfähigkeitsart, welche in einem Halbleitersubstrat (1) von entgegengesetzter Leitfähigkeitsart ausgebildet und jeweils mit einem ersten bzw. einem zweiten Energieversorgungsanschluß ($V_{SS}$, $V_{DD}$) verbunden sind, und mit einer Gateelektrode (5), welche auf einer Gateisolierschicht (4) auf dem Halbleitersubstrat zwischen dem ersten und dem zweiten Bereich vorgesehen ist, wobei der MIS-Feldeffekttransistor so ist, daß eine Durchgreifspannung, welche, wenn sie von einem Energieversorgungsanschluß dem mit diesem verbundenen Bereich zugeführt wird, einen Durchgriff in dem MIS-Feldeffekttransistor verursachen würde, kleiner als die Durchbruchspannung des PN-Übergangs zwischen dem Substrat und dem Bereich ist, mit welchem der Energieversorgungsanschluß verbunden ist, bei welcher die Schutzschaltung wenigstens eine Schutzeinrichtung (200) umfaßt, welche eine vorbestimmte Durchbruchspannung hat, die parallel zu einem Ladungsstromweg zwischen dem ersten Energieversorgungsanschluß und dem ersten Bereich oder parallel zu einem Ladungsstromweg zwischen dem zweiten Energieversorgungsaschluß und dem zweiten Bereich liegt, um die Zuführung einer exzessiven Spannung zu dem ersten Bereich zu verhindern bzw. um die Zuführung einer exzessiven Spannung zu dem zweiten Bereich zu verhindern, wobei die oder jede Schutzeinrichtung eine Druchbruchspannung hat, die kleiner als die Durchgreifspannung ist, welche, falls sie von dem mit der Schutzeinrichtung verbundenen Energieversorgungsanschluß dem mit dem Energieversorgungsanschluß verbundenen Bereich zugeführt wird, einen Druchgriff in dem MIS-Feldeffekttransistor verursachen würde.

2. Schutzschaltung in Kombination mit einem MIS-Feldeffekttransistor, nach Anspruch 1, mit einer Schutzeinrichtung, welche eine vorbestimmte Durchbruchspannung hat und parallel zu einem Ladungsstromweg zwischen dem ersten Energieversorgungsanschluß und dem ersten Bereich angeschlossen ist, und mit einer Schutzeinrichtung, welche eine vorbestimmte Durchbruchspannung hat und parallel zu einem Ladungsstromweg zwischen dem zweiten Energieversorgungsanschluß und dem zweiten Bereich angeschlossen ist, um die Zuführung exzessiver Spannungen zu dem ersten und dem zweiten Bereich zu verhindern.

3. Schutzschaltung in Kombination mit einem MIS-Feldeffekttransistor, nach Anspruch 1 oder 2, bei welcher die oder jede Schutzeinrichtung funktionsfähig ist, einen Bei-Pass-Weg für Ladungen vorzusehen, wenn eine exzessive Spannung von dem Energieversorgungsanschluß mit welchem die Schutzeinrichtung verbunden ist, zugeführt wird.

4. Schutzschaltung in Kombination mit einem MIS-Feldeffekttransistor nach einem der vorhergehenden Ansprüche, bei welcher die oder jede Schutzeinrichtung eine Gatesteuerdiode umfaßt, mit deren einer Elektrode eine vorbestimmte Spannung zugeführt wird, um die Durchbruchspannung für die Gatesteuerdiode niedriger als die Durchgreifspannung des MIS-Feldeffekttransistors zu legen.

5. Schutzschaltung in Kombination mit einem MIS-Feldeffekttransistor, nach Anspruch 4, bei welcher die vorbestimmte Spannung Erdpotential ist.

6. Schutzschaltung in Kombination mit einem MIS-Feldeffekttransistor, nach Anspruch 4, bei welcher die vorbestimmte Spannung die Substratspannung ist.

7. Schutzschaltung in Kombination mit einem MIS-Feldeffekttransistor, nach einem der Ansprüche 1 bis 3, bei welcher die oder jede Schutzeinrichtung eine Zenerdiode umfaßt, deren Durchbruchspannung kleiner als die Durchgreifspannung des MIS-Feldeffekttransistors ist.

8. Schutzschaltung in Kombination mit einem MIS-Feldeffekttransistor, nach einem der Ansprüche 1 bis 3, bei welcher die oder jede Schutzeinrichtung einen MIS-Feldeffekttransistor von Durchgriffstyp umfaßt, welcher eine Druchgreifspannung hat, die kleiner als die Durchgreifspannung des zu schützenden MIS-Feldeffekttransistors ist.

9. Schutzschaltung in Kombination mit einem MIS-Feldeffekttransistor, nach einem der vorhergehenden Ansprüche, bei welcher die Schutzeinrichtungen auf dem Halbleitersubstrat vorgesehen sind.

10. Schutzschaltung in Kombination mit einem MIS-Feldeffekttransistor, nach einem der vorhergehenden Ansprüche, bei welcher der erste Bereich ein Drainbereich eines MIS-Feldeffekttransistors, der zweite Bereich ein Sourcebereich eines MIS-Feldeffekttransistors, der erste Energieversorgungsanschluß eine Hochspannungsversorgungsanschluß und der zweite Energieversorgungsanschluß eine Niederspannungsanschluß ist.

## Revendications

1. Circuit de protection en combinaison avec un MISFET d'un circuit intégré semi-conducteur, pour protéger le MISFET, le MISFET comportant une première et une seconde régions (2, 3) d'un type de conductivité, formées dans un substrat semi-conducteur (1) du type opposé de conductivité, connectées respectivement à une première et une secondes bornes de source d'alimentation ($V_{SS}$, $V_{DD}$) et une grille (5) prévue sur une pellicule isolante de grille (4) sur le substrat semi-conducteur entre la première et la seconde régions, le MISFET étant tel qu'une tension de perçage qui, si elle est appliquée par une borne d'alimentation à la région connectée à cette borne d'alimentation, pourrait donner lieu à un phénomène de perçage dans le MISFET, est inférieure à une tension d'amorçage de la jonction (PN) entre le substrat et la région à laquelle la borne d'alimentation est connectée, dans lequel le circuit de protection comporte au moins un dispositif de protection (200) ayant une tension d'amorçage prédéterminée, connecté en parallèle avec un circuit d'écoulement de charges entre la première borne d'alimentation et la première région ou en parallèle avec un circuit d'acoulement de charges entre la seconde borne d'alimentation et la seconde région, pour éviter l'application d'une tension excessive à la première région ou pour éviter l'application d'une tension excessive à la seconde région respectivement, le ou chaque dispositif de protection ayant une tension d'amorçage inférieure à une tension de perçage qui, si elle est appliquée par la borne d'alimentation par rapport à laquelle le dispositif de protection est connecté, à la région connectée à cette borne d'alimentation, donnerait lieu à un phénomène de perçage dans le MISFET.

2. Circuit de protection en combinaison avec un MISFET, selon la revendication 1, comprenant un dispositif de protection ayant une tension d'amorçage prédéterminée et connectée en parallèle avec un circuit d'écoulement de charges entre la première borne d'alimentation et la première région et comprenant un dispositif de protection ayant une tension d'amorçage prédéterminée et connectée en parallèle avec un circuit d'écoulement de charges entre la seconde borne d'alimentation et la seconde région pour éviter l'application de tensions excessives à la première et à la seconde régions.

3. Circuit de protection en combinaison avec un MISFET, selon la revendication 1 ou 2, dans lequel le ou chaque dispositif de protection fonctionne pour établir un circuit de dérivation pour des charges quand une tension excessive est appliquée dans la borne d'alomentation à laquelle le dispositif de protection est connecté.

4. Circuit de protection en combinaison avec un MISFET selon l'une quelconque des revendications précédentes, dans lequel le ou chaque dispositif de protection comporte une diode à contrôle par grille à une grille de laquelle est appliquée une tension prédéterminée pour établir une tension d'amorçage pour la diode à contrôle par grille inférieure à la tension de perçage du MISFET.

5. Circuit de protection en combinaison avec un MISFET selon la revendication 4, dans lequel la tension prédéterminée est le potentiel de la masse.

6. Circuit de protection en combinaison avec un MISFET selon la revendication 4, dans lequel la tension prédéterminée est la tension du substrat.

7. Circuit de protection en combinaison avec un MISFET selon l'une quelconque des revendications 1 à 3 dans lequel le ou chaque dispositif de protection consiste en une diode zener dont la tension d'amorçage est inférieure à une tension de perçage du MISFET.

8. Circuit de protection en combinaison avec un MISFET selon l'une quelconque des revendications 1 à 3, dans lequel le ou chaque dispositif de protection consiste en un MISFET du type à perçage ayant une tension de perçage inférieure à une tension de perçage du MISFET à protéger.

9. Circuit de protection en combinaison avec un MISFET selon l'une quelconque des revendications précédentes, dans lequel le dispositif de protection est prévu sur ledit substrat semi-conducteur.

10. Circuit de protection en combinaison avec un MISFET selon l'une quelconque des revendications précédentes, dans lequel la première région est une région de drain d'un MISFET, la seconde région est une région de source d'un MISFET, la première borne d'alimentation est une borne d'alimentation en tension haute et la seconde borne d'alimentation est une borne d'alimentation en tension basse.

Fig. 1    (Prior art)

Fig. 3

Fig. 4

Fig. 5

Fig. 6

2

Fig 2

PN Junction Breakdown

Punch through Break down

$V_{PT}$ (volt)

20

15

10

5

1    1.5    2    2.5    L [µm]

Fig 7

Metallurgical Junction Breakdown

32V

[volt] $V_D$

15

10

5

Gate Controlled Junction Breakdown

-15    -10    -5    0    5    $V_g$ [volt]

Fig 8

Fig. 9

Fig.10